# EUROPEAN PATENT SPECIFICATION

(11) **EP 2 813 304 B1**
(45) Date of publication and mention of the grant of the patent: **11.11.2020**
(21) Application number: 14167458.0
(22) Date of filing: 08.05.2014
(51) Int. Cl.: B23B 27/00, B23C 5/10, B26D 1/00, B23K 26/57, B23K 26/36

(54) **Edge tool**
Abkantwerkzeug
Outil tranchant

(30) Priority: 20.05.2013 JP 2013106032
(43) Date of publication of application: 17.12.2014
(73) Proprietor: JAPAN AVIATION ELECTRONICS INDUSTRY, LIMITED, Shibuya-ku Tokyo 150-0043 (JP)
(72) Inventor: Suzuki, Akiko, Shibuya-ku, TOKYO 150-0043 (JP); Sato, Akinobu, Shibuya-ku, TOKYO 150-0043 (JP)
(74) Representative: MERH-IP Matias Erny Reichl Hoffmann Patentanwälte PartG mbB

(56) References cited:
- WO-A1-2007/099777
- DE-C1- 19 724 319
- JP-A- S63 237 821
- JP-A- 2008 229 838
- JP-A- 2010 036 297

## Description

### TECHNICAL FIELD

The present invention relates to an edge tool having a high durability used for cutting processing and so on.

### BACKGROUND ART

An essential property of an edge tool (referred to also as a cutting tool, hereinafter) used for cutting processing is durability, which indicates how resistant to wear the cutting part is and how long or how many times the edge tool can be used. In view of this, the cutting part of the cutting tool is made of a hard material that has high hardness and tends to resist wearing, such as a cubic boron nitride (cBN) sintered body, diamond, or a tungsten carbide sintered body referred to as a cemented carbide. As an alternative, a cutting part made of steel or the like may be coated with a hard material having a higher hardness than steel.

These hard materials are brittle materials having low ductility and tend to break because of a cracking or a chip (referred to also as chipping hereinafter) when an impact is applied thereto. Unlike metals, these brittle materials are hardly plastically deformed. Therefore, when an impact is applied to such a brittle material, the resulting stress is concentrated in a small scratch in the surface of the brittle material, which was formed during the manufacturing process, to expand the scratch. As a result, the scratch expands, and a cracking or chip develops from the scratch. The same holds true for a case where a coating of a hard material is formed on the cutting part, a cracking or a chip tends to occur in the coating in such a case.

As described above, if a hard material is used to reduce wear, a defect such as a cracking or chip is more likely to occur. In order to reduce both wear and occurrence of a cracking or chip, techniques for reducing occurrence of a cracking or chip of the hard material and improving the durability of the cutting tool while using a hard material for a cutting tool have been developed.

There is a well-known technique of removing a scratch or surface defect from which a cracking can develop by planarizing the surface of a hard material, in order to reduce occurrence of a cracking or chip of the hard material.

A polishing technique for planarizing the surface of a cutting part by mechanical polishing using abrasive grain is used for any materials.

Patent Literature 1 (Japanese Patent Application Laid-Open No. 2007-230807) discloses a thermochemical polishing technique that removes micro cracks on a surface resulting from mechanical polishing, as a technique for manufacturing a diamond product having high resistance to chipping.

Patent Literature 2 (Japanese Patent Application Laid-Open No. 2005-279822) discloses a technique that improves wear resistance and chip resistance of a throwaway chip made of a hard sintered body as a base body coated with a coating layer harder than the base body. The surface of the coating layer is polished in regions of the cutting edge from the rake face side to the flank side via the intersection ridge in such a manner that the surface roughness of the region of the cutting edge on the rake face side is smaller than the surface roughness of the region of the cutting edge on the flank side.

Patent Literature 3 (Japanese Patent Application Laid-Open No. 2012-176471) discloses a technique that improves wear resistance of a cutting tool having a tool base body made of tungsten carbide-based cemented carbide or titanium carbonitride-based cermet coated with a diamond layer. The tool base body is coated with a crystalline diamond layer and a nanodiamond layer, the cutting edge is then made sharper by removing the nanodiamond layer in the regions except for the cutting edge with ultraviolet laser, and at the same time, the surface layer of the rake face and the flank is modified by the laser to form a smooth amorphous carbon film.

Mechanical polishing of the surface of a cutting part made of a hard material for reducing occurrence of a cracking or chip can reduce the number of scratches, defects or the like having approximately the same size as the abrasive grain but cannot remove scratches formed by the abrasive grain itself (referred to as abrasion scratches, hereinafter). Therefore, although it can be expected that mechanical polishing is effective to some extent for preventing occurrence of a cracking or chip of the cutting part, occurrence of a cracking or chip of the cutting part can hardly sufficiently or completely prevented.

The thermochemical polishing technique disclosed in Patent Literature 1 can only be used for a material capable of thermochemical reaction.

The hard coating forming technique disclosed in Patent Literature 2 is a technique that polishes a hard coating in such a manner that the hard coating has a predetermined surface roughness, and therefore cannot sufficiently or completely prevent formation of abrasive scratches. In addition, according to this technique, it is difficult to sufficiently or completely prevent cracking or peel-off of the coating if the base body and the coating made of different materials are in inadequate contact with each other.

The hard coating forming technique disclosed in Patent Literature 3 involves forming a hard coating on a base body and therefore tends to result in cracking or peel-off of the hard coating as with the hard coating forming technique disclosed in Patent Literature 2. Prior art similar to those disclosed in patent literatures 1 to 3 is known from the documents JP S63 237821 A, JP 2010 036297 A, JP 2008 229838 A and DE 197 24 319 C1. The document of JP S63 237821 A discloses a diamond tool manufactured by a thermal process in the atmosphere or in a vacuum after irradiating an edge of the diamond tool with ions. The document of JP 2010 036297 A discloses a smoothing technique with a gas cluster ion beam by which a diamond coating film on a cemented carbide base is smoothed such that a first surface structure is formed on a rake face and a second surface structure is formed on a flank face, the surface structures having parallel grooves with lengths of 5 µm or more and surface roughness of 0.5 µm or less in maximum height or of 0.1 µm or less in center line average roughness. The document of JP 2008 229838 A discloses a diamond chip attached to a diamond tool, the diamond chip having periodic uneven structures with periods of 5 nm or more to 3000 nm or less that are formed by irradiation of a ultrashort pulse laser. The document of DE 197 24 319 C1 discloses a method for influencing the swarf flow behaviour of tool surfaces in the region of cutting edges with swarf producing tools with a geometrically defined cutter, by laser irradiation of the tool surface, wherein with the help of the laser irradiation at least the faces at a slight distance to the cutting surface are provided with a geometric pattern changing the surface structure.

### SUMMARY OF THE INVENTION

In view of such circumstances, an object of the present invention is to provide an edge tool that has high durability, i.e., high wear resistance and at the same time is unlikely to crack or chip when an impact or other force is applied thereto.

In view of this object, the present invention provides an edge tool having the features of independent claim 1 and an edge tool having the features of independent claim 6. The invention also provides a method of manufacturing such an edge tool with the features of independent claim 7. Preferred embodiments of the tool of the invention are described in dependent claims 2 to 5.

The present invention provides an edge tool having a rake face and a flank, the edge tool having, in a first region that is at least a part of the rake face, a first surface structure in which a network of first recesses and first protuberances surrounded by the first recesses are formed and having, in a second region that is at least a part of the flank, a second surface structure in which a network of second recesses and second protuberances surrounded by the second recesses are formed, and the edge tool having the features that (1) in a cross section of the first surface structure taken along a plane that intersects a boundary between the rake face and the flank, the number of first protuberances satisfying the condition that a first inclination is larger than a second inclination is greater than the number of first protuberances satisfying the condition that the first inclination is not larger than the second inclination, the first inclination being an inclination of the same one side surface of each protuberance which is included in the first protuberances, the one side surface leading to an adjacent recess on a side of the boundary, the second inclination being an inclination of the other side surface of each protuberance, and the other side surface leading to an adjacent recess on the opposite side to the boundary; a value of a physical property of the first surface structure differs from a value of the physical property of an interior of the edge tool lying below the first surface structure, and there is no solid-solid interface between the first surface structure and the interior of the edge tool, and (2) in a cross section of the second surface structure taken along a plane that intersects the boundary between the rake face and the flank, the number of second protuberances satisfying the condition that a third inclination is larger than a fourth inclination is greater than the number of second protuberances satisfying the condition that the third inclination is not larger than the fourth inclination, the third inclination being an inclination of the same one side surface of each protuberance which is included in the second protuberances, the one side surface leading to an adjacent recess on a side of the boundary, the fourth inclination being an inclination of the other side surface of each protuberance, and the other side surface leading to an adjacent recess on the opposite side to the boundary; a value of a physical property of the second surface structure differs from a value of the physical property of the interior of the edge tool lying below the second surface structure, and there is no solid-solid interface between the second surface structure and the interior of the edge tool.

Alternatively, the present invention provides an edge tool having a rake face and a flank, the edge tool having, in a first region that is at least a part of the rake face, a first surface structure in which a network of first recesses and first protuberances surrounded by the first recesses are formed and having, in a second region that is at least a part of the flank, a second surface structure in which a network of second recesses and second protuberances surrounded by the second recesses are formed, and the edge tool having features that (1) in a cross section of the first surface structure taken along a plane that intersects a boundary between the rake face and the flank, the number of first protuberances satisfying the condition that a first inclination is larger than a second inclination is greater than the number of first protuberances satisfying the condition that the first inclination is not larger than the second inclination, the first inclination being an inclination of the same one side surface of each protuberance which is included in the first protuberances, the one side surface leading to an adjacent recess on a side of the boundary, the second inclination being an inclination of the other side surface of each protuberance, and the other side surface leading to an adjacent recess on the opposite side to the boundary; the first surface structure has an amorphous structure, an interior of the edge tool lying below the first surface structure has a crystalline structure, and a boundary region between the interior of the edge tool and the first surface structure has a structure that gradually changes from the crystalline structure to the amorphous structure as it goes from the interior of the edge tool to the first surface structure, and (2) in a cross section of the second surface structure taken along a plane that intersects the boundary between the rake face and the flank, the number of second protuberances satisfying the condition that a third inclination is larger than a fourth inclination is greater than the number of second protuberances satisfying the condition that the third inclination is not larger than the fourth inclination, the third inclination being an inclination of the same one side surface of each protuberance which is included in the second protuberances, the one side surface leading to an adjacent recess on a side of the boundary, the fourth inclination being an inclination of the other side surface of each protuberance, and the other side surface leading to an adjacent recess on the opposite side to the boundary; the second surface structure has an amorphous structure, the interior of the edge tool lying below the second surface structure has a crystalline structure, and a boundary region between the interior of the edge tool and the second surface structure has a structure that gradually changes from the crystalline structure to the amorphous structure as it goes from the interior of the edge tool to the second surface structure.

Each of the first surface structure and the second surface structure can be formed by irradiation with a gas cluster ion beam.

### EFFECTS OF THE INVENTION

An edge tool according to the present invention has a surface structure having the characteristics (1) to (3) described below on at least a part of a rake face thereof and at least a part of a flank thereof and therefore has high wear resistance and is unlikely to crack or chip when an impact is applied thereto: (1) there is no solid-solid interface between the surface structure and the interior of the edge tool, (2) the value of a physical property of the surface structure differs from a value of the physical property of the interior of the edge tool, or more specifically, the surface structure has a value of a physical property that more easily permits the surface structure to be elastically or plastically deformed than a value of the physical property of the interior of said edge tool, and (3) the surface structure has such a shape that the surface structure is elastically or plastically deformed as the surface structure rubs against a workpiece.

### BRIEF DESCRIPTION OF THE DRAWINGS

Figs. 1 are diagrams for illustrating a relationship between a cutting part of a cutting tool and a workpiece, Fig. 1(a) showing the cutting part cutting into the workpiece, and Fig. 1(b) showing the progress of the cutting;
Fig. 2 is a diagram for illustrating a preferred shape characteristic of a protuberance;
Fig. 3A is a diagram for illustrating the degree of a stress concentration alleviating function of a protuberance whose rising angle is greater than the falling angle;
Fig. 3B is a diagram for illustrating the degree of a stress concentration alleviating function of a protuberance whose rising angle is not greater than the falling angle;
Fig. 4 is a diagram for illustrating a plane intersecting a boundary between a rake face and a flank;
Fig. 5 is a diagram for illustrating the rake face and the flank irradiated with a single gas cluster ion beam;
Figs. 6 are diagrams for illustrating a surface structure formed on the rake face by obliquely irradiating the rake face with a gas cluster ion beam, Fig. 6(a) being an atomic force microscopic (AFM) image, Fig. 6(b) showing a cross-sectional profile, Fig. 6(c) being a schematic perspective view for illustrating a part of the edge tool observed with the atomic force microscopic image, and Fig. 6(d) being a plan view for illustrating the part of the edge tool observed with the atomic force microscopic image;
Fig. 7 is a diagram showing details of Fig. 6(b), Fig. 7(a) showing the cross-sectional profile shown in Fig. 6(b), and Fig. 7(b) showing a result of analysis of the cross-sectional profile;
Figs. 8 are diagrams showing a surface structure formed on the flank by obliquely irradiating the flank with a gas cluster ion beam, Fig. 8(a) showing a scanning electron microscopic image, Fig. 8(b) being a schematic diagram showing a part of Fig. 8(a), and Fig. 8(c) being a schematic diagram showing a cross-sectional curve along a line L3 to L4 in Fig. 8(b);
Fig. 9A is a diagram showing an example of an edge tool (a cutting tool) and the shape of a cutting part thereof;
Fig. 9B is a diagram showing an example of an edge tool (a circular saw) and the shape of a cutting part thereof;
Fig. 9C is a diagram showing an example of an edge tool (a square endmill) and the shape of a cutting part thereof;
Figs. 10 are diagrams showing a surface structure on a cutting edge of a cutting part in Example 1, Fig. 10(a) showing a scanning electron microscopic image of the cutting edge, Fig. 10(b) being a schematic diagram showing a part of Fig. 10(a), Fig. 10(c) being a schematic diagram showing a cross-sectional curve along a line L5 to L6 in Fig. 10(b), and Fig. 10(d) being a schematic diagram showing a cross-sectional curve along a line L7 to L8 in Fig. 10(b); and
Figs. 11 are diagrams for illustrating a definition of the amount of loss, Fig. 11(a) showing the position of the boundary between the rake face and the flank before use, and Fig. 11(b) showing a starting point S of the ridge formed by two worn flanks.

### DETAILED DESCRIPTION

Factors that affect the life of an edge tool having a rake face and a flank include a phenomenon of wear of the rake face and the flank. The phenomenon of wear causes deformation of the cutting part or deterioration of the sharpness of the cutting part and therefore deterioration of the performance of the edge tool, such as the sharpness and the cutting precision.

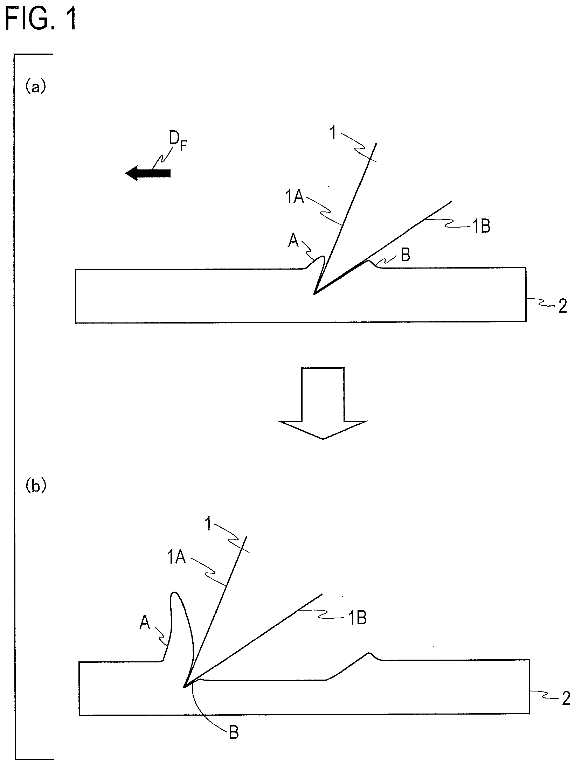

Taking a cutting tool as an example of the edge tool, the phenomenon can be explained as follows. Figs. 1 show a relationship between a cutting part 1 of the cutting tool and a workpiece 2 to be processed by the cutting tool. In Figs. 1, the arrow denoted by reference symbol D_{F} represents a direction of travel (direction of advance) of the cutting tool. As shown in Fig. 1(a), when the cutting part 1 cuts into the workpiece 2, parts A and B of the workpiece 2 around the cutting part 1 cutting into the workpiece 2 (referred to simply as material parts A and B, hereinafter) become humped on the sides of a rake face 1A and a flank 1B of the cutting part 1. The material part A rubs against the rake face 1A, and the material part B rubs against the flank 1B. In addition, in the course of the cutting process, it can be considered that the cutting of the cutting part 1 into the workpiece 2 moves. As sown in Fig. 1(b), the material part A formed in front of the cutting tool in the direction of travel grows into a chip having some size while rubbing against the rake face 1A, and the material part B formed behind the cutting tool in the direction of travel continues to rub against the flank 1B, with the material part B usually not separating off the workpiece 2. During such rubbing, the material parts A and B may apply a force to the rake face 1A and the flank 1B, respectively. If a force is applied to a brittle material used as a material of an edge tool, the resulting stress is concentrated in a small scratch in the surface of the edge tool, which was formed during the manufacturing process, to expand the scratch. As a result, the scratch expands, and a cracking or chip develops from the scratch. Thus, the rake face 1A wears because of the material part A rubbing against the rake face 1A, and the flank 1B wears because of the material part B rubs against the flank 1B.

Therefore, if the rake face or flank is made less susceptible to wear, the mechanical durability or the physical durability of the edge tool can be improved. More specifically, if the rake face and the flank each have a stress concentration alleviating structure that alleviates the stress concentration in the edge tool in the vicinity of the rake face and the flank produced by the force applied by the workpiece, occurrence of a cracking or chip due to stress concentration can be reduced. In addition, such a stress concentration alleviating structure can reduce the frictional force between the edge tool and the workpiece and therefore can reduce the wear of the edge tool.

In view of the points described above, according to the present invention, a surface structure having a stress concentration alleviating function is formed each of at least a part of the rake face and at least a part of a flank of the edge tool, thereby reducing wear of the cutting part. Essential characteristics of the surface structure are as follows.
(1) There is no solid-solid interface between the surface structure and the interior of the edge tool.
(2) A physical property value of the surface structure differs from a physical property value of the interior of the edge tool. Specifically, the surface structure has a physical property value that more easily permits the surface structure to be elastically or plastically deformed than a physical property value of the interior of said edge tool. Hereafter, a physical property value is also referred to as a value of a physical property.
(3) The surface structure has such a shape that the surface structure is elastically or plastically deformed as the surface structure rubs against the workpiece.

First, the reason why the condition (1) is needed is as follows: if there is a solid-solid interface between the surface structure and the interior of the edge tool lying below the surface structure, the surface structure can peel off the edge tool beginning at the solid-solid interface. Note that the solid-solid interface herein is defined as a boundary at which the value of a physical property discontinuously changes between the surface structure and the interior of the edge tool. The part of the edge tool from which the surface structure has peeled off has a sharp step-like edge, and the stress tends to be concentrated in the vicinity of the edge and cause a chip or cracking of the cutting part. For example, a method of depositing diamond-like carbon by chemical vapor deposition cannot be used, because the method involves formation of a solid-solid interface.

Next, the condition (2) will be described. The surface structure has to have a function of alleviating stress concentration in a scratch when an external force is applied to the rake face or flank, so that a value of a physical property of the surface structure has to differ from a value of the physical property of the interior of the edge tool on the same measure of physical property. More specifically, the surface structure has to have a value of a physical property that more easily permits the surface structure to be elastically or plastically deformed than a value of the physical property of the interior of said edge tool on the same measure of physical property. The physical property can be selected from among physical properties relating to the mechanical durability or the physical durability, and Young's modulus, density, hardness, degree of amorphousness (or degree of crystallinity), percentage of voids and others can be exemplified as a measure of the physical property. A value of a physical property is a value of an object to be measured on such a measure of physical property.

In the case where Young's modulus is chosen, a value of Young's modulus of the surface structure is smaller than a value of Young's modulus of the interior of the edge tool lying below the surface structure. Hereafter, a value of Young's modulus is also simply referred to as a Young's modulus.

In the case where density is chosen, a value of density of the surface structure is lower than a value of density of the interior of the edge tool lying below the surface structure. Hereafter, a value of density is also simply referred to as a density.

In the case where hardness is chosen, a value of hardness of the surface structure is lower than a value of hardness of the interior of the edge tool lying below the surface structure. Hereafter, a value of hardness is also simply referred to as a hardness.

In the case where degree of amorphousness (or degree of crystallinity) is chosen, it is supposed that the surface structure has an amorphous structure and the interior of the edge tool lying below the surface structure has a crystalline structure. In that case, a transition region from the interior of the edge tool to the surface structure has a structure that gradually changes from the crystalline structure to the amorphous structure as it goes from the interior of the edge tool to the surface structure. A value of degree of amorphousness of the surface structure is greater than a value of degree of amorphousness of the interior of the edge tool. Or, a value of degree of crystallinity of the surface structure is lower than a value of degree of crystallinity of the interior of the edge tool. Hereafter, a value of degree of crystallinity is also simply referred to as a degree of crystallinity.

In the case where percentage of voids is chosen, a value of percentage of voids of the surface structure is higher than a value of percentage of voids of the interior of the edge tool lying below the surface structure. Hereafter, a value of percentage of voids is also simply referred to as a percentage of voids.

The conditions (1) and (2) can be bound together as follows. That is, specific examples of the condition that "a value of a physical property of the surface structure differs from a value of the physical property of the interior of the edge tool lying below the surface structure, and there is no solid-solid interface between the surface structure and the interior of the edge tool" are "a Young's modulus of the surface structure is smaller than a Young's modulus of the interior of the edge tool lying below the surface structure, and the transition region from the interior of the edge tool to the surface structure has a structure that gradually changes in Young's modulus as it goes from the interior of the edge tool to the surface structure", "a density of the surface structure is lower than a density of the interior of the edge tool lying below the surface structure, and the transition region from the interior of the edge tool to the surface structure has a structure that gradually changes in density as it goes from the interior of the edge tool to the surface structure", "a hardness of the surface structure is lower than a hardness of the interior of the edge tool lying below the surface structure, and the transition region from the interior of the edge tool to the surface structure has a structure that gradually changes in hardness as it goes from the interior of the edge tool to the surface structure", "the surface structure has an amorphous structure, the interior of the edge tool lying below the surface structure has a crystalline structure, and the transition region from the interior of the edge tool to the surface structure has a structure that gradually changes from the crystalline structure to the amorphous structure as it goes from the interior of the edge tool to the surface structure (that is, a degree of crystallinity of the surface structure is lower than a degree of crystallinity of the interior of the edge tool)", or "a percentage of voids of the surface structure is higher than a percentage of voids of the interior of the edge tool lying below the surface structure, and the transition region from the interior of the edge tool to the surface structure has a structure that gradually changes in percentage of voids as it goes from the interior of the edge tool to the surface structure".

Next, the condition (3) will be described. The surface structure has to have a function of alleviating stress concentration in a scratch when an external force is applied to the rake face or flank, so that the surface structure has to have such a shape that the surface structure is elastically or plastically deformed when the surface structure rubs against the workpiece.

As a result of investigations, the inventors have found that a surface structure in which a network of recesses and protuberances surrounded by the recesses will work. The protuberances preferably have an average width equal to or greater than 5 nm and equal to or smaller than 600 nm. The "average width of the protuberances" is used as an indicator of a horizontal dimension of a protuberance, because all the protuberances do not always have the same size or shape. More specifically, in the front view of the surface structure, the diameter of the smallest circle containing a protuberance is determined per protuberance, and the average value of the diameters is defined as the "average width of the protuberances". The average width of the protuberances is preferably equal to or greater than 5 nm because a too small protuberance is deformed until the structure change reaches a point of saturation before alleviating the stress concentration and therefore cannot adequately serve the stress concentration alleviating function. On the other hand, the average width of the protuberances is preferably equal to or smaller than 600 nm because if the average width of the protuberances is too great, stress concentration occurs as in the case of the structure having no protuberances (that is, the surface structure provides no stress concentration alleviating function).

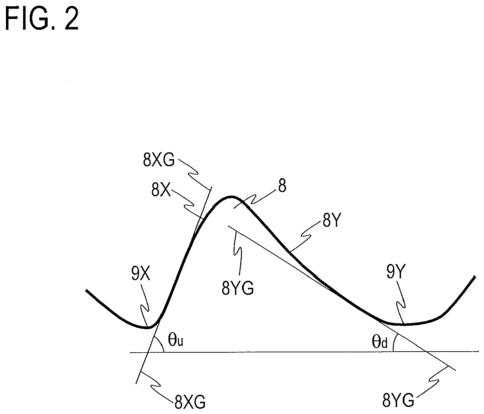

As a result of further investigations, the inventors have found the protuberances preferably have shape characteristics described below. The preferred shape characteristics will be described with reference to Fig. 2.

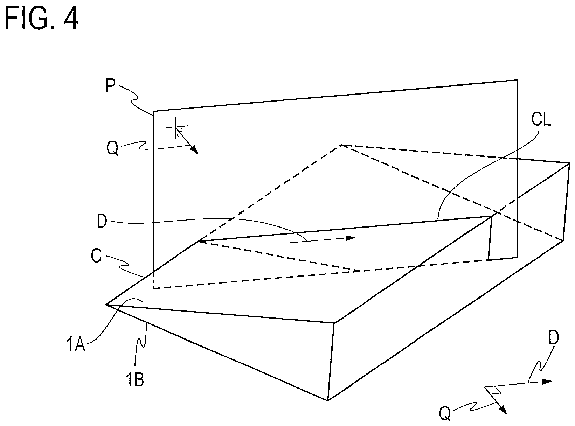

Fig. 2 shows a cross section of the surface structure taken along a plane P (the plane P will be described later with reference to Fig. 4) intersecting a boundary C between the rake face 1A and the flank 1B. The protuberance 8 is preferably shaped so that, in the cross section, an inclination 8XG of a side surface 8X of the protuberance 8 is greater than an inclination 8YG of a side surface 8Y of the protuberance 8, wherein the side surface 8X connects to a recess 9X adjacent to the protuberance 8 on the side of the boundary C and the side surface 8Y connects to a recess 9Y adjacent to the same protuberance 8 on the opposite side to the boundary C.

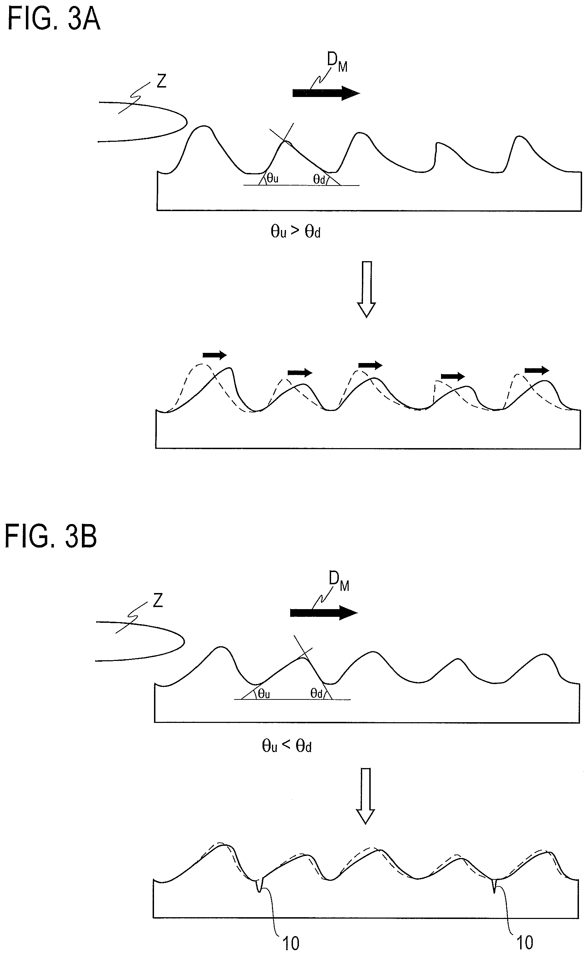

With such a shape, as shown in Fig. 3A, when a material part Z (reference symbol Z denotes reference symbol A or B) rubs against the rake face 1A or the flank 1B during processing, the protuberance 8 can be substantially deformed in the direction of relative travel of the material part Z and therefore can sufficiently serve the stress concentration alleviating function inside the surface structure. To the contrary, if the protuberance 8 is shaped so that, in the cross section, the inclination 8XG of the side surface 8X of the protuberance 8 is not greater than the inclination 8YG of the side surface 8Y of the protuberance 8, as shown in Fig. 3B, when the material part Z rubs against the rake face 1A or the flank 1B during processing, the protuberance 8 cannot be substantially deformed in the direction of relative travel of the material part Z and therefore cannot sufficiently serve the stress concentration alleviating function inside the surface structure. Therefore, cracks 10 are likely to occur. Incidentally, in Figs. 3A and 3B, the arrow denoted by reference symbol D_{M} represents the direction of relative travel of the material part Z with respect to the rake face 1A or flank 1B.

The "plane P intersecting the boundary C between the rake face 1A and the flank 1B" is any of the planes excluding (a) a plane including the boundary C and (b) a plane whose normal is a straight line perpendicular to the boundary C on the assumption that the boundary C is a straight line in a local region. The plane P used to consider the cross section of the surface structure on the rake face 1A is preferably a plane whose normal Q is a straight line perpendicular to a direction D in which the material part A travels while rubbing against the rake face 1A during processing with the edge tool (in other words, the plane P is preferably a plane such that a line of intersection CL of this plane and the rake face 1A is parallel with the direction D). The plane P is more preferably a plane that forms an angle of 90 degrees with the plane of the rake face 1A on the assumption that the rake face 1A is a flat surface in the vicinity of the line of intersection CL (see Fig. 4). Similarly, although not shown, the plane P used to consider the cross section of the surface structure on the flank 1B is preferably a plane whose normal is a straight line perpendicular to the direction in which the material part B travels while rubbing against the flank 1B during processing with the edge tool (in other words, the plane P is preferably a plane such that a line of intersection of this plane and with the flank 1B is parallel with the direction of travel of the material part B). The plane P is more preferably a plane that forms an angle of 90 degrees with the plane of the flank 1B on the assumption that the flank 1B is a flat surface in the vicinity of the line of intersection of the plane P with the flank 1B (this can be easily understood by replacing the "rake face 1A" and the "flank 1B" in Fig. 4 by the "flank 1B" and the "rake face 1A", respectively). If the direction of travel of the material parts A and B while rubbing against the rake face 1A and the flank 1B during processing with the edge tool is not known, the boundary C in a local region can be regarded as a straight line, and a plane whose normal is the boundary C can be adopted as the plane P.

Various indicators can be used as the "inclination 8XG" and the "inclination 8YG". For example, a "local slope" defined in Japanese Industrial Standard JIS B0601:2013 can be used. In the case where the local slope is used, in the cross section described above, on the assumption that a "contour curve" is a "cross-sectional curve" or "roughness curve" (note: "contour curve", "cross-sectional curve" and "roughness curve" are called in JIS B0601:2013 "profile", "primary profile" and "roughness profile", respectively), the absolute value of the local slope of a part of the contour curve showing the side surface 8X of the protuberance 8 connecting to the recess 9X can be used as the inclination 8XG, wherein the part is in the vicinity of the recess 9X, and similarly, the absolute value of the local slope of a part of the contour curve showing the side surface 8Y of the protuberance 8 connecting to the recess 9Y can be used as the inclination 8YG, wherein the part is in the vicinity of the recess 9Y

As an alternative, the indicator described below can be used as the "inclination 8XG" and the "inclination 8YG".

As shown in Fig. 2, on the assumption that the "contour curve" is said "cross-sectional curve" or said "roughness curve", an angle θᵤ (referred to as a rising angle θᵤ hereinafter) formed by an "average line for determining the cross-sectional curve" defined in Japanese Industrial Standard JIS B0601:2013 or a straight line parallel with the average line and an approximate straight line of a part of the contour curve showing the side surface 8X of the protuberance 8 connecting to the recess 9X is regarded as the inclination 8XG, wherein the part of the contour curve is in the vicinity of the recess 9X (note: "average line for determining the cross-sectional curve" is called "mean line for the primary profile" in JIS B0601:2013), and an angle θ_{d} (referred to as a falling angle θ_{d} hereinafter) formed by the average line and an approximate straight line of a part of the contour curve showing the side surface 8Y of the protuberance 8 connecting to the recess 9Y is regarded as the inclination 8YG, wherein the part of the contour curve is in the vicinity of the recess 9Y.

All the protuberances of the surface structure do not always have to have the shape characteristics described above. Here referring to the inclination of the side surface of the protuberance leading to the adjacent recess on the side of the boundary (i.e., the inclination of the one side surface of the protuberance, wherein the one side surface connects to the recess adjacent to the protuberance on the side of the boundary) as a first inclination, and referring to the inclination of the side surface of the same protuberance leading to the adjacent recess on the opposite side to the boundary (i.e., the inclination of the other side surface of the protuberance, wherein the other side surface connects to the recess adjacent to the same protuberance on the opposite side to the boundary) as a second inclination, it is essential that the number of protuberances satisfying the condition that the first inclination is larger than the second inclination is greater than the number of protuberances satisfying the condition that the first inclination is not larger than the second inclination.

Such a surface structure is formed on both the rake face and the flank of the edge tool. However, the shape, the physical properties or the like of the surface structure formed on one of the rake face and the flank may differ from those of the surface structure formed on the other. The parts of the rake face and the flank on which the surface structure is formed are preferably parts that are to rub against the material parts, and the surface structure can typically be formed over substantially the entire surface of the cutting part of the edge tool.

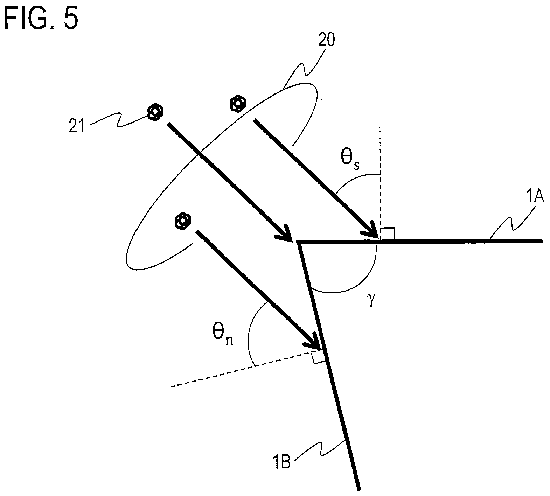

The inventors have found that a surface structure that satisfies all of the three conditions (1), (2) and (3) described above can be formed by obliquely irradiating the edge tool, in particular the surface of the cutting part thereof, with a gas cluster ion beam. Preferably, the surface structures on both the rake face and the flank can be concurrently formed with a single gas cluster ion beam by irradiating the boundary between the rake face and the flank (that is, a cutting edge) with the gas cluster ion beam. More specifically, as shown in Fig. 5, provided that an angle of irradiation measured with respect to the normal to the rake face is denoted by θₛ, and an angle of irradiation measured with respect to the normal to the flank is denoted by θₙ, the edge tool can be irradiated with a single gas cluster ion beam 20 under conditions that the angles of irradiation satisfy the relations: 0 < θₛ < 90°, and 0 < θₙ < 90°. In Fig. 5, reference numeral 21 denotes a gas cluster ion. More preferably, if the boundary between the rake face and the flank is irradiated with the gas cluster ion beam in such a manner that the direction of irradiation agrees with the direction in which the material parts travel while rubbing against the rake face and the flank during processing with the edge tool, a large number of protuberances can be formed which have the preferred shape characteristics described above in the cross section of the cutting part taken along the plane P whose normal is a straight line perpendicular to the direction in which the material parts A and B travel while rubbing against the rake face 1A and the flank 1B during processing with the edge tool.

With regard to the condition (1), formation of the solid-solid interface can be prevented by irradiating the surface of the edge tool with the gas cluster ion beam to cause the physical structure of a surface layer of the edge tool to change to be continuous to the crystalline structure or physical properties of the hard material of the interior of the edge tool. With regard to the condition (2), when the surface of the edge tool is irradiated with the gas cluster ion beam, sputtering or horizontal displacement of the material occurs on the surface of the edge tool irradiated with the gas cluster ion beam, and the atomic arrangement in the surface layer changes. In response to this change, a value of a physical property relating to the mechanical durability, such as a Young's modulus, a density, a hardness, a degree of crystallization, or a percentage of voids, changes.

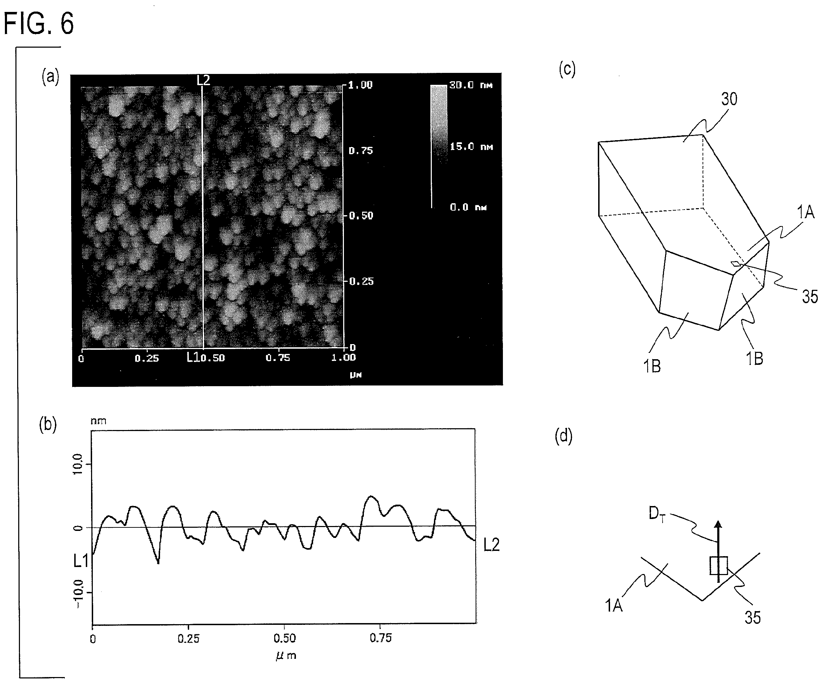

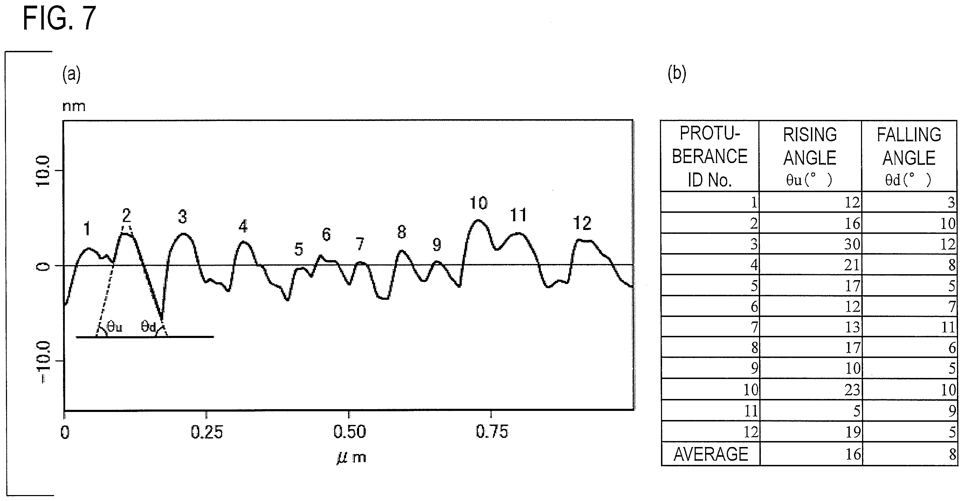

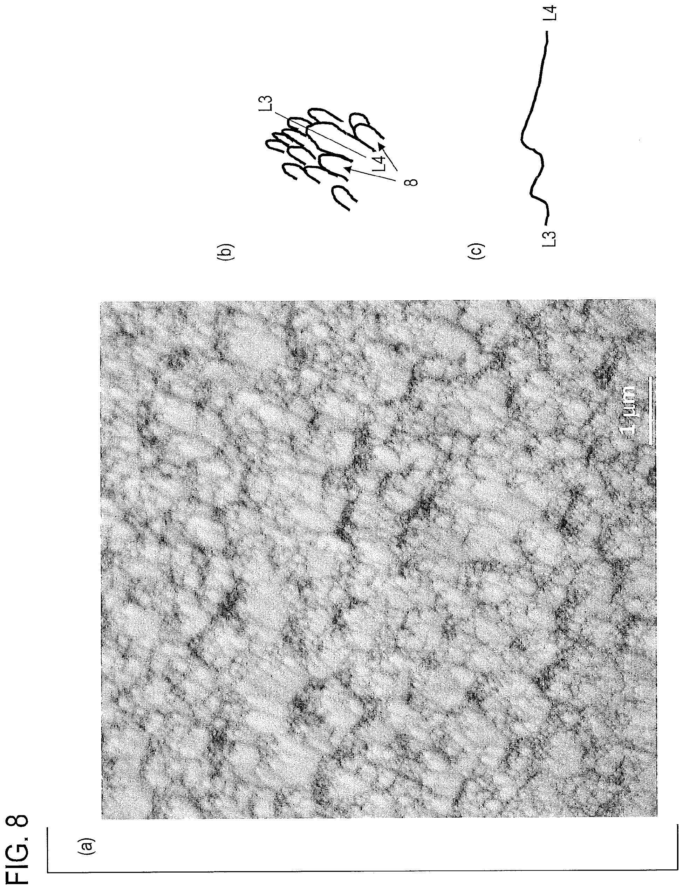

With regard to the condition (3), an experiment example will be described. Figs. 6(a) and 6(b) show an atomic force microscopic image and a cross-sectional profile of a surface structure formed on the rake face 1A by irradiating the rake face 1A with a gas cluster ion beam at an angle of 5° with respect to the normal to the rake face 1A. A point of AFM observation 35 on an edge tool 30 observed with the atomic force microscopic image is shown in Figs. 6(c) and 6(d). In Fig. 6(d), reference symbol D_{T} denotes a direction of travel of a material part being processed. The widths of the protuberances were evaluated in the atomic force microscopic image shown in Fig. 6(a), and it was found that the widths of the protuberances (measured in the direction perpendicular to a measurement line L1 to L2 in the cross-sectional profile) fell within a range from 5 nm to 50 nm. Figs. 7 show a result of analysis of the cross-sectional profile shown in Fig. 6(b). The rising angles θᵤ and the falling angles θ_{d} of the observed twelve protuberances were evaluated. The evaluation showed that the rising angle θᵤ was larger than the falling angle θ_{d} for all the protuberances except for the eleventh protuberance from the boundary (see Figs. 7). This result as well as other results of formation of surface structures with different angles of irradiation showed that the widths of the protuberances formed by irradiation with a gas cluster ion beam approximately fell within a range from 5 nm to 500 nm. Fig. 8(a) shows an atomic force microscopic image of a surface structure formed on the flank by obliquely irradiating the flank with a gas cluster ion beam. Fig. 8(b) is a schematic diagram of a part of Fig. 8(a), and Fig. 8(c) is a schematic diagram showing a cross-sectional curve along a line L3 to L4 in Fig. 8(b). In this example, the widths of the protuberances 8 were approximately 50 nm to 600 nm.

As a condition for irradiation with a gas cluster ion beam, the irradiation energy needs to be greater than the interatomic bond energy, for example. More specifically, each atom forming the gas cluster needs to have an energy of several eV or higher. In a typical example, in order to produce a gas cluster formed by 1000 atoms each having an energy of 5 eV or higher, the irradiation energy needs to be 5 keV (5kV in terms of acceleration voltage) or higher. In other respects, such as the kind of the raw material gas, there is no particular limitation.

The process of forming the surface structure on the rake face and the flank is not limited to the irradiation with the gas cluster ion beam, and any process that can form the surface structure described above can be used.

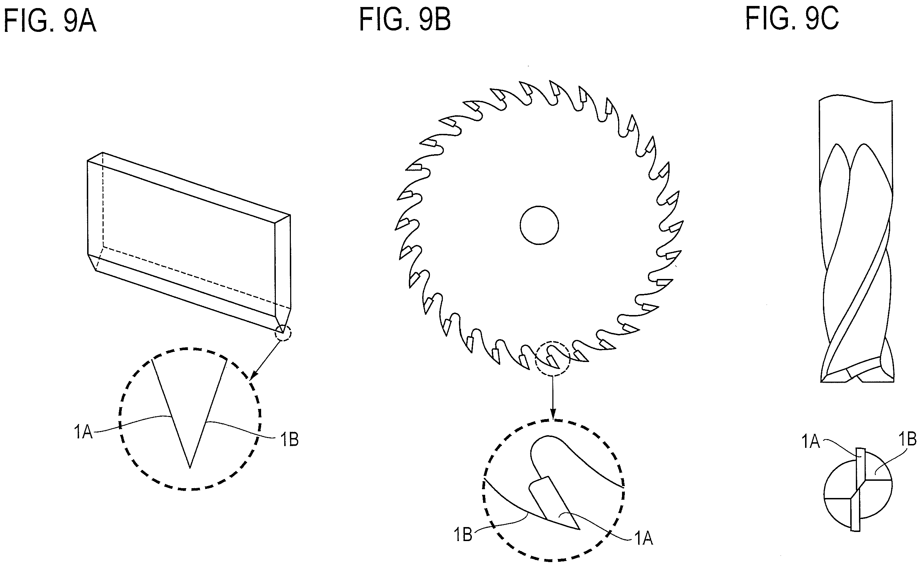

The edge tool shown in Fig. 6(c) has one rake face 1A and two flanks 1B. However, the edge tool according to the present invention is not limited to the shape. For example, the edge tool having any shape, such as a cutting tool, a circular saw, and a square endmill shown in Figs. 9A, 9B and 9C, respectively, is possible as far as the edge tool has a cutting part having a cutting edge formed by surfaces that serve as a rake face 1A and a flank 1B.

The material of the edge tool can be any hard material but typically is single-crystalline diamond or ceramics, such as binderless cBN (cubic boron nitride) sintered body, a polycrystalline diamond sintered body, a cBN sintered body, a tungsten carbide sintered body, an alumina sintered body or a zirconia sintered body. Alternatively, a brittle material, such as hard steel, single-crystalline silicon or glass, can also be used as the material for the edge tool.

A process of forming the cutting part involves forming the outer shape of the edge tool by laser beam processing, wire discharge processing or the like and then polishing the resulting cutting part. In the case of a hard material, such as single-crystalline diamond or binderless cBN sintered body, a process referred to as scaife polishing is often used.

In the following, examples and comparative examples using typical conditions and cutting test results therefor will be described.

### [Example 1]

To fabricate a cutting tool having a cutting part made of single-crystalline diamond, a block having a thickness of 1 mm, a length of 2 mm and a width of 2 mm was cut from a single-crystalline diamond material by laser processing. The block was then shaped by cutting the surfaces with a diamond grindstone, and the cutting part was polished and finished with a scaife grinding machine. The wedge angle γ was 80°.

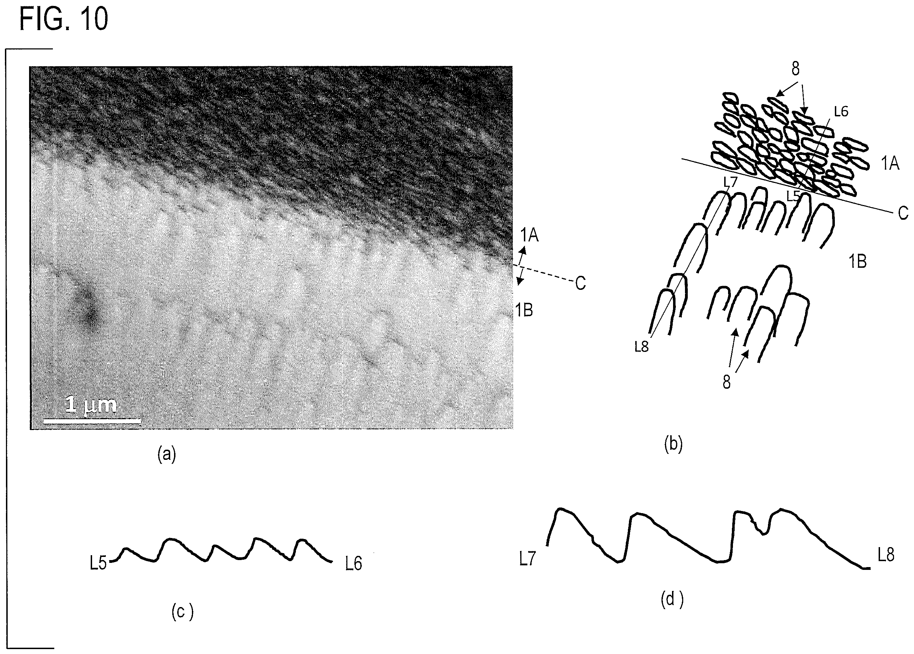

The cutting part was irradiated with a gas cluster ion beam under the condition that θₛ = 40°, and θₙ = 60° as shown in Fig. 5. The raw material gas used was argon, the acceleration voltage was 20 kV, and the irradiation dose was 4 × 10¹⁸ ions/cm². Fig. 10(a) shows a result of observation of the cutting edge of the irradiated cutting part with a scanning electron microscope. Fig. 10(b) is a schematic diagram showing a part of Fig. 10(a), Fig. 10(c) is a schematic diagram showing a cross-sectional curve along a line L5 to L6 in Fig. 10(b), and Fig. 10(d) is a schematic diagram showing a cross-sectional curve along a line L7 to L8 in Fig. 10(b). A large number of protuberances whose rising angle θᵤ was greater than the falling angle θ_{d} were formed on each of the rake face 1A and the flank 1B. The widths of the protuberances 8 on the rake face 1A were 10 nm to 200 nm, and the widths of the protuberances 8 on the flank 1B were 50 nm to 300 nm.

On the assumption that a Young's modulus, a density, a hardness, a degree of crystallization and a percentage of voids of the surface of the cutting part yet to be irradiated with the gas cluster ion beam were 1, a Young's modulus, a density, a hardness, a degree of crystallization and a percentage of voids of the surface structure formed by irradiation with the gas cluster ion beam were determined. The surface structure on the rake face 1A had a Young's modulus of 0.78, a density of 0.88, a hardness of 0.75, a degree of crystallization of 0.32, and a percentage of voids of 0.86. The surface structure on the flank 1B had a Young's modulus of 0.31, a density of 0.70, a hardness of 0.11, a degree of crystallization of 0.09, and a percentage of voids of 0.89.

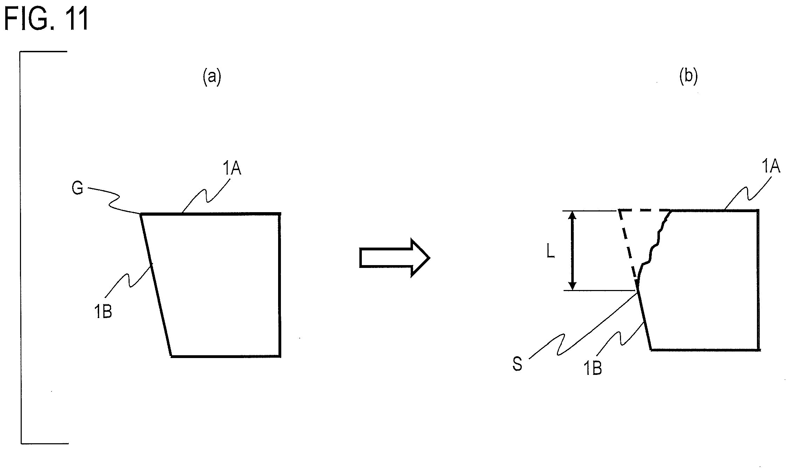

A stainless steel alloy was cut with an endmill edge having the above-described cutting part. The amount of loss L of the endmill edge at the time when the cut distance reached 40 m was evaluated with the scanning electron microscope. As shown in Figs. 11, considering the case where the cutting part wears during use, the amount of loss L is defined as the distance between the position of a tip G formed by the rake face 1A and the two flanks 1B before use (see Fig. 11(a)) and the starting point S of the ridge formed by two worn flanks 1B (see Fig. 11(b)). The amount of loss of a part that wore the most was 0.7 µm. The worn part of the cutting part had a smooth shape, and no chip or cracking was observed.

### [Comparative Example 1]

A cutting tool made of single-crystalline diamond was fabricated in the same manner as in Example 1 except that irradiation with the gas cluster ion beam was omitted. The surface configurations of the rake face and the flank of the cutting part were checked with the scanning electron microscope. The surface structure described above was not observed on the rake face and the flank.

The same cutting test as in Example 1 was performed using the cutting tool made of single-crystalline diamond in Comparative Example 1, and the amount of loss L was evaluated. The amount of loss L was 3.8 µm. In addition, the shape of the worn part was closely observed with the scanning electron microscope. Then, a surface configuration was observed in which minute crackings were concentrated and a cracked surface is exposed.

### [Examples 2, 3, 4]

A cutting part made of single-crystalline diamond was irradiated with a gas cluster ion beam to form a surface structure on a rake face and a flank. Three types of cutting parts were formed under different conditions of irradiation with the gas cluster ion beam. All the surface structures had a large number of protuberances whose rising angle θᵤ was greater than the falling angle θ_{d}. The rising angle θᵤ and the falling angle θ_{d} were measured for representative 50 protuberances, and the percentage of the protuberances that satisfy a relation that θᵤ > θ_{d} was determined. In addition, the cutting test was performed in the same manner as in Example 1, and the amount of loss was evaluated. The results are shown in Table 1.

### [Comparative Examples 2, 3, 4]

Cutting parts made of single-crystalline diamond were fabricated in the same manner as in Examples 2, 3 and 4 except that a surface structure having a large number of protuberances whose rising angle θᵤ was not greater than the falling angle θ_{d} was formed on the rake face and the flank. The rising angle θᵤ and the falling angle θ_{d} were measured for representative 50 protuberances, and the percentage of the protuberances that satisfy a relation that θᵤ > θ_{d} was determined. In addition, the cutting test was performed in the same manner as in Example 1, and the amount of loss was evaluated. The results are shown in Table 1.

### [Examples 5, 6, 7]

A cutting part made of sintered diamond was irradiated with a gas cluster ion beam to form a surface structure on a rake face and a flank. Three types of cutting parts were formed under different conditions of irradiation with the gas cluster ion beam. All the surface structures had a large number of protuberances whose rising angle θᵤ was greater than the falling angle θ_{d}. The rising angle θᵤ and the falling angle θ_{d} were measured for representative 50 protuberances, and the percentage of the protuberances that satisfy a relation that θᵤ > θ_{d} was determined. In addition, the cutting test was performed in the same manner as in Example 1, and the amount of loss was evaluated. The results are shown in Table 1.

### [Comparative Examples 5, 6, 7]

Cutting parts made of sintered diamond were fabricated in the same manner as in Examples 5, 6 and 7 except that a surface structure having a large number of protuberances whose rising angle θᵤ was not greater than the falling angle θ_{d} was formed on the rake face and the flank. The rising angle θᵤ and the falling angle θ_{d} were measured for representative 50 protuberances, and the percentage of the protuberances that satisfy a relation that θᵤ > θ_{d} was determined. In addition, the cutting test was performed in the same manner as in Example 1, and the amount of loss was evaluated. The results are shown in Table 1.

### [Examples 8, 9, 10]

A cutting part made of binderless cBN sintered body was irradiated with a gas cluster ion beam to form a surface structure on a rake face and a flank. Three types of cutting parts were formed under different conditions of irradiation with the gas cluster ion beam. All the surface structures had a large number of protuberances whose rising angle θᵤ was greater than the falling angle θ_{d}. The rising angle θᵤ and the falling angle θ_{d} were measured for representative 50 protuberances, and the percentage of the protuberances that satisfy a relation that θᵤ > θ_{d} was determined. In addition, the cutting test was performed in the same manner as in Example 1, and the amount of loss was evaluated. The results are shown in Table 1.

### [Comparative Examples 8, 9, 10]

Cutting parts made of binderless cBN sintered body were fabricated in the same manner as in Examples 8, 9 and 10 except that a surface structure having a large number of protuberances whose rising angle θᵤ was not greater than the falling angle θ_{d} was formed on the rake face and the flank. The rising angle θᵤ and the falling angle θ_{d} were measured for representative 50 protuberances, and the percentage of the protuberances that satisfy a relation that θᵤ > θ_{d} was determined. In addition, the cutting test was performed in the same manner as in Example 1, and the amount of loss was evaluated. The results are shown in Table 1.

**[Table 1]**

| | MATERIAL | PERCENTAGE (%) OF PROTUBERANCES WITH θᵤ > θ_{d} ON RAKE FACE | PERCENTAGE (%) OF PROTUBERANCES WITH θᵤ > θ_{d} ON FLANK | AMOUNT OF LOSS | |
|---|---|---|---|---|---|
| | | | | L (µm) | |
| EXAMPLE 2 | SINGLE-CRYSTAL DIAMOND | 88 | 90 | 1.2 | LOW |
| EXAMPLE 3 | SINGLE-CRYSTAL DIAMOND | 92 | 94 | 0.9 | LOW |
| EXAMPLE 4 | SINGLE-CRYSTAL DIAMOND | 94 | 96 | 0.6 | L OW |
| COMPARATIVE EXAMPLE 2 | SINGLE-CRYSTAL DIAMOND | 4 | 8 | 2.9 | HIGH |
| COMPARATIVE EXAMPLE 3 | SINGLE-CRYSTAL DIAMOND | 8 | 12 | 2.7 | HIGH |
| COMPARATIVE | SINGLE-CRYSTAL | 8 | 10 | 2.6 | HIGH |
| EXAMPLE 4 | DIAMOND | | | | |
| | | | | | |
| EXAMPLE 5 | SINTERED DIAMOND | 94 | 94 | 1.5 | LOW |
| EXAMPLE 6 | SINTERED DIAMOND | 90 | 88 | 1.8 | LOW |
| EXAMPLE 7 | SINTERED DIAMOND | 92 | 96 | 1.3 | LOW |
| COMPARATIVE EXAMPLE 5 | SINTERED DIAMOND | 10 | 8 | 3.5 | HIGH |
| COMPARATIVE EXAMPLE 6 | SINTERED DIAMOND | 12 | 10 | 3.3 | HIGH |
| COMPARATIVE EXAMPLE 7 | SINTERED DIAMOND | 8 | 12 | 3.6 | HIGH |
| | | | | | |
| EXAMPLE 8 | BINDERLESS cBN | 88 | 86 | 1.4 | LOW |
| EXAMPLE 9 | BINDERLESS cBN | 92 | 92 | 1 | LOW |
| EXAMPLE 10 | BINDERLESS cBN | 96 | 94 | 0.7 | LOW |
| COMPARATIVE EXAMPLE 8 | BINDERLESS cBN | 6 | 4 | 3.1 | HIGH |
| COMPARATIVE EXAMPLE 9 | BINDERLESS cBN | 8 | 10 | 2.9 | HIGH |
| COMPARATIVE EXAMPLE 10 | BINDERLESS cBN | 12 | 8 | 2.4 | HIGH |

### <CONSIDERATIONS>

From Example 1 and Comparative Example 1, it can be seen that, if a surface structure having a value of a physical property (a Young's modulus, a density, a hardness, a degree of crystallization, or a percentage of voids) different from a value of the physical property of the interior of the edge tool on the same measure of physical property and having a large number of protuberances whose rising angle θᵤ is greater than the falling angle θ_{d} is formed on each of the rake face and the flank by irradiation with a gas cluster ion beam, the loss of the cutting part is substantially reduced compared with the case where such a surface structure is not formed. Furthermore, in Example 1, no cracking or chip occurred in the cutting part, so that it can be seen that stress concentration was effectively alleviated. Furthermore, from the fact that the worn surface was smooth, it can be seen that wear slowly proceeded in small steps in terms of microscopic region. That is, it can be seen that adequate stress concentration alleviating effect and a low-friction cutting process were achieved. On the other hand, as for the cutting tool in Comparative Example 1, it can be seen that the cutting part wore as a result of accumulation of crackings, and stress concentration was not adequately alleviated.

Comparing Examples 2 to 10 with Comparative Examples 2 to 10, it can be seen that the amount of loss is low in the case where a large number of protuberances whose rising angle θᵤ is greater than the falling angle θ_{d} are formed, while the amount of loss is high in the case where a large number of protuberances whose rising angle θᵤ is not greater than the falling angle θ_{d} are formed. That is, it can be said that the protuberances whose rising angle θᵤ is greater than the falling angle θ_{d} are easily elastically of plastically deformed when a force is applied thereto by the workpiece during cutting compared with the protuberances whose rising angle θᵤ is not greater than the falling angle θ_{d}.

From Examples 1 to 10, it can be seen that the effect of preventing wear of the cutting part does not depend on the material of the cutting part.

In any of Examples, the edge tool has no hard coating or the like formed on the cutting part. However, the surface structure described above can also be formed on a hard coating or the like formed on the surface of the cutting part. Even if the hard coating is formed on the surface of the cutting part, the surface structure has the stress concentration alleviating effect, so that occurrence of cracking or peel-off of the coating can be reduced in the case where the surface structure described above is formed on the hard coating compared with the case where the surface structure described above is not formed on the hard coating, and the durability of the edge tool can be improved. That is, according to the present invention, the durability of a wide variety of edge tools can be improved regardless of the configuration of the surface of the edge tool.

The edge tool according to the present invention is not limited to a tool used in a machine tool that uses a mechanical force but can be a tool (a saw or a chisel, for example) used for working with human power, such as cutting and carving.

The foregoing description of the embodiments of the invention has been presented for the purpose of illustration and description. It is not intended to be exhaustive or to limit the invention to the precise form disclosed. Modifications or variations are possible in light of the above teachings. The embodiment was chosen and described to provide the illustration of the principles of the invention and its practical application, and to enable one of ordinary skill in the art to utilize the invention in various embodiments and with various modifications as are suited to the particular use contemplated. All such modifications and variations are within the scope of the invention as determined by the appended claims.

## Claims

1. An edge tool having a rake face (1A) and a flank (1B), wherein said edge tool has, in a first region that is at least a part of said rake face (1A), a first surface structure in which a network of first recesses (9X, 9Y) and first protuberances (8) surrounded by the first recesses (9X, 9Y) are formed,
in a cross section of said first surface structure taken along a plane (P) that intersects a boundary (C) between said rake face (1A) and said flank (1B), the number of first protuberances (8) satisfying the condition that a first inclination (8XG) is larger than a second inclination (8YG) is greater than the number of first protuberances (8) satisfying the condition that the first inclination (8XG) is not larger than the second inclination (8YG), the first inclination (8XG) being an inclination of the same one side surface (8X) of each protuberance (8) which is included in the first protuberances (8), the one side surface (8X) leading to an adjacent recess (9X) on a side of the boundary (C), the second inclination (8YG) being an inclination of the other side surface (8Y) of each protuberance (8), and the other side surface (8Y) leading to an adjacent recess (9Y) on the opposite side to the boundary (C),
a value of a physical property of said first surface structure differs from a value of the physical property of an interior of said edge tool lying below said first surface structure,
there is no solid-solid interface between said first surface structure and the interior of said edge tool,
said edge tool has, in a second region that is at least a part of said flank (1B), a second surface structure in which a network of second recesses (9X, 9Y) and second protuberances (8) surrounded by the second recesses (9X, 9Y) are formed,
in a cross section of said second surface structure taken along a plane (P) that intersects the boundary (C) between said rake face (1A) and said flank (1B), the number of second protuberances (8) satisfying the condition that a third inclination (8XG) is larger than a fourth inclination (8YG) is greater than the number of second protuberances (8) satisfying the condition that the third inclination (8XG) is not larger than the fourth inclination (8YG), the third inclination (8XG) being an inclination of the same one side surface (8X) of each protuberance (8) which is included in the second protuberances (8), the one side surface (8X) leading to an adjacent recess (9X) on a side of the boundary (C), the fourth inclination (8YG) being an inclination of the other side surface (8Y) of each protuberance (8), and the other side surface (8Y) leading to an adjacent recess (9Y) on the opposite side to the boundary (C),
a value of a physical property of said second surface structure differs from a value of the physical property of the interior of said edge tool lying below said second surface structure, and
there is no solid-solid interface between said second surface structure and the interior of said edge tool.

2. The edge tool according to claim 1,
wherein the value of the physical property is a Young's modulus,
a Young's modulus of said first surface structure is smaller than a Young's modulus of an interior of said edge tool lying below said first surface structure, and
a Young's modulus of said second surface structure is smaller than a Young's modulus of the interior of said edge tool lying below said second surface structure.

3. An edge tool according to claim 1,
wherein the value of the physical property is a density,
a density of said first surface structure is lower than a density of an interior of said edge tool lying below said first surface structure, and
a density of said second surface structure is smaller than a density of the interior of said edge tool lying below said second surface structure.

4. An edge tool according to claim 1,
wherein the value of the physical property is a hardness,
a hardness of said first surface structure is lower than a hardness of an interior of said edge tool lying below said first surface structure, and
a hardness of said second surface structure is lower than a hardness of the interior of said edge tool lying below said second surface structure.

5. An edge tool according to claim 1,
wherein the value of the physical property is a percentage of voids,
a percentage of voids of said first surface structure is higher than a percentage of voids of an interior of said edge tool lying below said first surface structure, and
a percentage of voids of said second surface structure is higher than a percentage of voids of the interior of said edge tool lying below said second surface structure.

6. An edge tool having a rake face (1A) and a flank (1B), wherein said edge tool has, in a first region that is at least a part of said rake face (1A), a first surface structure in which a network of first recesses (9X, 9Y) and first protuberances (8) surrounded by the first recesses (9X, 9Y) are formed,
in a cross section of said first surface structure taken along a plane (P) that intersects a boundary (C) between said rake face (1A) and said flank (1B), the number of first protuberances (8) satisfying the condition that a first inclination (8XG) is larger than a second inclination (8YG) is greater than the number of first protuberances (8) satisfying the condition that the first inclination (8XG) is not larger than the second inclination (8YG), the first inclination (8XG) being an inclination of the same one side surface (8X) of each protuberance (8) which is included in the first protuberances (8), the one side surface (8X) leading to an adjacent recess (9X) on a side of the boundary (C), the second inclination (8YG) being an inclination of the other side surface (8Y) of each protuberance (8), and the other side surface (8Y) leading to an adjacent recess (9Y) on the opposite side to the boundary (C),
said first surface structure has an amorphous structure, an interior of the edge tool lying below said first surface structure has a crystalline structure, and a boundary region between the interior of said edge tool and said first surface structure has a structure that gradually changes from the crystalline structure to the amorphous structure as it goes from the interior of said edge tool to said first surface structure,
said edge tool has, in a second region that is at least a part of said flank (1B), a second surface structure in which a network of second recesses (9X, 9Y) and second protuberances (8) surrounded by the second recesses (9X, 9Y) are formed,
in a cross section of said second surface structure taken along a plane (P) that intersects the boundary (C) between said rake face (1A) and said flank (1B), the number of second protuberances (8) satisfying the condition that a third inclination (8XG) is larger than a fourth inclination (8YG) is greater than the number of second protuberances (8) satisfying the condition that the third inclination (8XG) is not larger than the fourth inclination (8YG), the third inclination (8XG) being an inclination of the same one side surface (8X) of each protuberance (8) which is included in the second protuberances (8), the one side surface (8X) leading to an adjacent recess (9X) on a side of the boundary (C), the fourth inclination (8YG) being an inclination of the other side surface (8Y) of each protuberance (8), and the other side surface (8Y) leading to an adjacent recess (9Y) on the opposite side to the boundary (C), and
said second surface structure has an amorphous structure, the interior of the edge tool lying below said second surface structure has a crystalline structure, and a boundary region between the interior of said edge tool and said second surface structure has a structure that gradually changes from the crystalline structure to the amorphous structure as it goes from the interior of said edge tool to said second surface structure.

7. A method of manufacturing an edge tool according to any of claims 1 to 6,
wherein each of said first surface structure and said second surface structure is formed by irradiation with a gas cluster ion beam.

## Patentansprüche

1. Abkantwerkzeug mit einer Spanfläche (1A) und einer Flanke (1B),
wobei das Abkantwerkzeug in einem ersten Bereich, der mindestens ein Teil der Spanfläche (1A) ist, eine erste Oberflächenstruktur aufweist, in der ein Netzwerk von ersten Vertiefungen (9X, 9Y) und ersten Vorsprüngen (8), die von den ersten Vertiefungen (9X, 9Y) umgeben sind, ausgebildet ist,
in einem Querschnitt der ersten Oberflächenstruktur entlang einer Ebene (P), die eine Grenze (C) zwischen der Spanfläche (1A) und der Flanke (1B) schneidet, die Anzahl erster Vorsprünge (8), die die Bedingung erfüllen, dass eine erste Neigung (8XG) größer ist als eine zweite Neigung (8YG), größer ist als die Anzahl erster Vorsprünge (8), die die Bedingung erfüllen, dass die erste Neigung (8XG) nicht größer ist als die zweite Neigung (8YG), wobei die erste Neigung (8XG) eine Neigung der gleichen einen Seitenfläche (8X) jedes Vorsprungs (8) ist, die in den ersten Vorsprüngen (8) enthalten ist, wobei die eine Seitenfläche (8X) zu einer benachbarten Vertiefung (9X) auf einer Seite der Grenze (C) führt, wobei die zweite Neigung (8YG) eine Neigung der anderen Seitenfläche (8Y) jedes Vorsprungs (8) ist, und wobei die andere Seitenfläche (8Y) zu einer benachbarten Vertiefung (9Y) auf der gegenüberliegenden Seite der Grenze (C) führt,
ein Wert einer physikalischen Eigenschaft der ersten Oberflächenstruktur sich von einem Wert der physikalischen Eigenschaft eines Inneren des Abkantwerkzeugs , das unter der ersten Oberflächenstruktur liegt, unterscheidet,
keine Festkörper-Festkörper-Grenzfläche zwischen der ersten Oberflächenstruktur und dem Inneren des Abkantwerkzeugs vorhanden ist,
das Abkantwerkzeug in einem zweiten Bereich, der mindestens Teil der Flanke (1B) ist, eine zweite Oberflächenstruktur aufweist, in der ein Netzwerk von zweiten Vertiefungen (9X, 9Y) und zweiten Vorsprüngen (8), die von den zweiten Vertiefungen (9X, 9Y) umgeben sind, ausgebildet ist,
in einem Querschnitt der zweiten Oberflächenstruktur entlang einer Ebene (P), die die Grenze (C) zwischen der Spanfläche (1A) und der Flanke (1B) schneidet, die Anzahl zweiter Vorsprünge (8), die die Bedingung erfüllen, dass eine dritte Neigung (8XG) größer ist als eine vierte Neigung (8YG), größer ist als die Anzahl zweiter Vorsprünge (8), die die Bedingung erfüllen, dass die dritte Neigung (8XG) nicht größer ist als die vierte Neigung (8YG), wobei die dritte Neigung (8XG) eine Neigung der gleichen einen Seitenfläche (8X) jedes Vorsprungs (8) ist, die in den zweiten Vorsprüngen (8) enthalten ist, wobei die eine Seitenfläche (8X) zu einer benachbarten Vertiefung (9X) auf einer Seite der Grenze (C) führt, wobei die vierte Neigung (8YG) eine Neigung der anderen Seitenfläche (8Y) jedes Vorsprungs (8) ist, und wobei die andere Seitenfläche (8Y) zu einer benachbarten Vertiefung (9Y) auf der gegenüberliegenden Seite der Grenze (C) führt,
ein Wert einer physikalischen Eigenschaft der zweiten Oberflächenstruktur sich von einem Wert der physikalischen Eigenschaft des Inneren des Abkantwerkzeugs, das unter der zweiten Oberflächenstruktur liegt, unterscheidet, und keine Festkörper-Festkörper-Grenzfläche zwischen der zweiten Oberflächenstruktur und dem Inneren des Abkantwerkzeugs vorhanden ist.

2. Abkantwerkzeug nach Anspruch 1,
wobei der Wert der physikalischen Eigenschaft ein Elastizitätsmodul ist,
ein Elastizitätsmodul der ersten Oberflächenstruktur kleiner ist als ein Elastizitätsmodul eines Inneren des Abkantwerkzeugs, das unter der ersten Oberflächenstruktur liegt, und
ein Elastizitätsmodul der zweiten Oberflächenstruktur kleiner ist als ein Elastizitätsmodul des Inneren des Abkantwerkzeugs, das unter der zweiten Oberflächenstruktur liegt.

3. Abkantwerkzeug nach Anspruch 1,
wobei der Wert der physikalischen Eigenschaft eine Dichte ist,
eine Dichte der ersten Oberflächenstruktur geringer ist als eine Dichte eines Inneren des Abkantwerkzeugs, das unter der ersten Oberflächenstruktur liegt, und eine Dichte der zweiten Oberflächenstruktur geringer ist als eine Dichte des Inneren des Abkantwerkzeugs, das unter der zweiten Oberflächenstruktur liegt.

4. Abkantwerkzeug nach Anspruch 1,
wobei der Wert der physikalischen Eigenschaft eine Härte ist,
eine Härte der ersten Oberflächenstruktur geringer ist als eine Härte eines Inneren des Abkantwerkzeugs, das unter der ersten Oberflächenstruktur liegt, und eine Härte der zweiten Oberflächenstruktur geringer ist als eine Härte des Inneren des Abkantwerkzeugs, das unter der zweiten Oberflächenstruktur liegt.

5. Abkantwerkzeug nach Anspruch 1,
wobei der Wert der physikalischen Eigenschaft ein prozentualer Anteil von Hohlräumen ist,
der prozentuale Anteil von Hohlräumen der ersten Oberflächenstruktur höher ist als ein prozentualer Anteil von Hohlräumen eines Inneren des Abkantwerkzeugs, das unter der ersten Oberflächenstruktur liegt, und
der prozentuale Anteil von Hohlräumen der zweiten Oberflächenstruktur höher ist als ein prozentualer Anteil von Hohlräumen des Inneren des Abkantwerkzeugs, das unter der zweiten Oberflächenstruktur liegt.

6. Abkantwerkzeug mit einer Spanfläche (1A) und einer Flanke (1B),
wobei das Abkantwerkzeug in einem ersten Bereich, der mindestens ein Teil der Spanfläche (1A) ist, eine erste Oberflächenstruktur aufweist, in der ein Netzwerk von ersten Vertiefungen (9X, 9Y) und ersten Vorsprüngen (8), die von den ersten Vertiefungen (9X, 9Y) umgeben sind, ausgebildet ist,
in einem Querschnitt der ersten Oberflächenstruktur entlang einer Ebene (P), die eine Grenze (C) zwischen der Spanfläche (1A) und der Flanke (1B) schneidet, die Anzahl erster Vorsprünge (8), die die Bedingung erfüllen, dass eine erste Neigung (8XG) größer ist als eine zweite Neigung (8YG), größer ist als die Anzahl erster Vorsprünge (8), die die Bedingung erfüllen, dass die erste Neigung (8XG) nicht größer ist als die zweite Neigung (8YG), wobei die erste Neigung (8XG) eine Neigung der gleichen einen Seitenfläche (8X) jedes Vorsprungs (8) ist, die in den ersten Vorsprüngen (8) enthalten ist, wobei die eine Seitenfläche (8X) zu einer benachbarten Vertiefung (9X) auf einer Seite der Grenze (C) führt, wobei die zweite Neigung (8YG) eine Neigung der anderen Seitenfläche (8Y) jedes Vorsprungs (8) ist, und
die andere Seitenfläche (8Y) zu einer benachbarten Vertiefung (9Y) auf der gegenüberliegenden Seite der Grenze (C) führt,
die erste Oberflächenstruktur eine amorphe Struktur aufweist, wobei ein Inneres des Abkantwerkzeugs, das unter der ersten Oberflächenstruktur liegt, eine kristalline Struktur aufweist, und ein Grenzbereich zwischen dem Inneren des Abkantwerkzeugs und der ersten Oberflächenstruktur eine Struktur aufweist, die sich vom Inneren des Abkantwerkzeugs zur ersten Oberflächenstruktur allmählich von der kristallinen Struktur zur amorphen Struktur ändert,
das Abkantwerkzeug in einem zweiten Bereich, der mindestens ein Teil der Flanke (1B) ist, eine zweite Oberflächenstruktur aufweist, in der ein Netzwerk von zweiten Vertiefungen (9X, 9Y) und zweiten Vorsprüngen (8), die von den zweiten Vertiefungen (9X, 9Y) umgeben sind, ausgebildet ist,
in einem Querschnitt der zweiten Oberflächenstruktur entlang einer Ebene (P), die die Grenze (C) zwischen der Spanfläche (1A) und der Flanke (1B) schneidet, die Anzahl zweiter Vorsprünge (8), die die Bedingung erfüllen, dass eine dritte Neigung (8XG) größer ist als eine vierte Neigung (8YG), größer ist als die Anzahl zweiter Vorsprünge (8), die die Bedingung erfüllen, dass die dritte Neigung (8XG) nicht größer ist als die vierte Neigung (8YG), wobei die dritte Neigung (8XG) eine Neigung der gleichen einen Seitenfläche (8X) jedes Vorsprungs (8) ist, die in den zweiten Vorsprüngen (8) enthalten ist, wobei die eine Seitenfläche (8X) zu einer benachbarten Vertiefung (9X) auf einer Seite der Grenze (C) führt, wobei die vierte Neigung (8YG) eine Neigung der anderen Seitenfläche (8Y) jedes Vorsprungs (8) ist, und die andere Seitenfläche (8Y) zu einer benachbarten Vertiefung (9Y) auf der gegenüberliegenden Seite der Grenze (C) führt, und
die zweite Oberflächenstruktur eine amorphe Struktur aufweist, wobei das Innere des Abkantwerkzeugs, das unter der zweiten Oberflächenstruktur liegt, eine kristalline Struktur aufweist, und ein Grenzbereich zwischen dem Inneren des Abkantwerkzeugs und der zweiten Oberflächenstruktur eine Struktur aufweist, die sich vom Inneren des Abkantwerkzeugs zur zweiten Oberflächenstruktur allmählich von der kristallinen Struktur zur amorphen Struktur ändert.

7. Verfahren zur Herstellung eines Abkantwerkzeugs nach einem der Ansprüche 1 bis 6,
wobei sowohl die erste Oberflächenstruktur als auch die zweite Oberflächenstruktur durch Bestrahlung mit einem Gascluster-Ionenstrahl gebildet wird.

## Revendications

1. Outil tranchant ayant une face de coupe (1A) et un flanc (1B) dans lequel
ledit outil tranchant a, dans une première région qui est au moins une partie de ladite face de coupe (1A), une première structure de surface dans laquelle est formé un réseau de premiers évidements (9X, 9Y) et de premières protubérances (8) entourées par les premiers évidements (9X, 9Y),
dans une section transversale de ladite première structure de surface prise le long d'un plan (P) qui croise une limite (C) entre ladite face de coupe (1A) et ledit flanc (1B), le nombre de premières protubérances (8) satisfaisant la condition selon laquelle une première inclinaison (8XG) est plus importante qu'une deuxième inclinaison (8YG) est supérieur au nombre de premières protubérances (8) satisfaisant la condition selon laquelle la première inclinaison (8XG) n'est pas plus importante que la deuxième inclinaison (8YG), la première inclinaison (8XG) étant une inclinaison de la même première surface latérale (8X) de chaque protubérance (8) qui est incluse dans les premières protubérances (8), la première surface latérale (8X) conduisant à un évidement adjacent (9X) sur un côté de la limite (C), la deuxième inclinaison (8YG) étant une inclinaison de l'autre surface latérale (8Y) de chaque protubérance (8), et l'autre surface latérale (8Y) conduisant à un évidement adjacent (9Y) du côté opposé à la limite (C),
une valeur d'une propriété physique de ladite première structure de surface diffère d'une valeur de la propriété physique de l'intérieur dudit outil tranchant se trouvant sous ladite première structure de surface,
il n'y a pas d'interface solide-solide entre ladite première structure de surface et l'intérieur dudit outil tranchant,
ledit outil tranchant a, dans une deuxième région qui est au moins une partie dudit flanc (1B), une deuxième structure de surface dans laquelle est formé un réseau de deuxièmes évidements (9X, 9Y) et de deuxièmes protubérances (8) entourées par les deuxièmes évidements (9X, 9Y),
dans une section transversale de ladite deuxième structure de surface prise le long d'un plan (P) qui croise la limite (C) entre ladite face de coupe (1A) et ledit flanc (1B), le nombre de deuxièmes protubérances (8) satisfaisant la condition selon laquelle une troisième inclinaison (8XG) est plus importante qu'une quatrième inclinaison (8YG) est supérieur au nombre de deuxièmes protubérances (8) satisfaisant la condition selon laquelle la troisième inclinaison (8XG) n'est pas plus importante que la quatrième inclinaison (8YG), la troisième inclinaison (8XG) étant une inclinaison de la même première surface latérale (8X) de chaque protubérance (8) qui est incluse dans les deuxièmes protubérances (8), la première surface latérale (8X) conduisant à un évidement adjacent (9X) sur un côté de la limite (C), la quatrième inclinaison (8YG) étant une inclinaison de l'autre surface latérale (8Y) de chaque protubérance (8), et l'autre surface latérale (8Y) conduisant à un évidement adjacent (9Y) du côté opposé à la limite (C),
une valeur d'une propriété physique de ladite deuxième structure de surface diffère d'une valeur de la propriété physique de l'intérieur dudit outil tranchant se trouvant sous ladite deuxième structure de surface, et
il n'y a pas d'interface solide-solide entre ladite deuxième structure de surface et l'intérieur dudit outil tranchant.

2. Outil tranchant selon la revendication 1,
dans lequel la valeur de la propriété physique est un module de Young,
un module de Young de ladite première structure de surface est plus petit qu'un module de Young de l'intérieur dudit outil tranchant se trouvant sous ladite première structure de surface, et
un module de Young de ladite deuxième structure de surface est plus petit qu'un module de Young de l'intérieur dudit outil tranchant se trouvant sous ladite deuxième structure de surface.

3. Outil tranchant selon la revendication 1,
dans lequel la valeur de la propriété physique est une densité,
une densité de ladite première structure de surface est inférieure à une densité de l'intérieur dudit outil tranchant se trouvant sous ladite première structure de surface, et
une densité de ladite deuxième structure de surface est plus petite qu'une densité de l'intérieur dudit outil tranchant se trouvant sous ladite deuxième structure de surface.

4. Outil tranchant selon la revendication 1,
dans lequel la valeur de la propriété physique est une dureté,
une dureté de ladite première structure de surface est inférieure à une dureté de l'intérieur dudit outil tranchant se trouvant sous ladite première structure de surface, et
une dureté de ladite deuxième structure de surface est inférieure à une dureté de l'intérieur dudit outil tranchant se trouvant sous ladite deuxième structure de surface.

5. Outil tranchant selon la revendication 1,
dans lequel la valeur de la propriété physique est un pourcentage de vide, un pourcentage de vide de ladite première structure de surface est supérieur à un pourcentage de vide de l'intérieur dudit outil tranchant se trouvant sous ladite première structure de surface, et
un pourcentage de vide de ladite deuxième structure de surface est supérieur à un pourcentage de vide de l'intérieur dudit outil tranchant se trouvant sous ladite deuxième structure de surface.

6. Outil tranchant ayant une face de coupe (1A) et un flanc (1B), dans lequel
ledit outil tranchant a, dans une première région qui est au moins une partie de ladite face de coupe (1A), une première structure de surface dans laquelle est formé un réseau de premiers évidements (9X, 9Y) et de premières protubérances (8) entourées par les premiers évidements (9X, 9Y),
dans une section transversale de ladite première structure de surface prise le long d'un plan (P) qui croise une limite (C) entre ladite face de coupe (1A) et ledit flanc (1B), le nombre de premières protubérances (8) satisfaisant la condition selon laquelle une première inclinaison (8XG) est plus importante qu'une deuxième inclinaison (8YG) est supérieur au nombre de premières protubérances (8) satisfaisant la condition selon laquelle la première inclinaison (8XG) n'est pas plus importante que la deuxième inclinaison (8YG), la première inclinaison (8XG) étant une inclinaison de la même première surface latérale (8X) de chaque protubérance (8) qui est incluse dans les premières protubérances (8), la première surface latérale (8X) conduisant à un évidement adjacent (9X) sur un côté de la limite (C), la deuxième inclinaison (8YG) étant une inclinaison de l'autre surface latérale (8Y) de chaque protubérance (8), et l'autre surface latérale (8Y) conduisant à un évidement adjacent (9Y) du côté opposé à la limite (C),
ladite première structure de surface a une structure amorphe, l'intérieur de l'outil tranchant se trouvant sous ladite première structure de surface a une structure cristalline, et une région de limite entre l'intérieur dudit outil tranchant et ladite première structure de surface a une structure qui passe progressivement de la structure cristalline à la structure amorphe à mesure qu'elle va de l'intérieur dudit outil tranchant à ladite première structure de surface,
ledit outil tranchant a, dans une deuxième région qui est au moins une partie dudit flanc (1B), une deuxième structure de surface dans laquelle est formé un réseau de deuxièmes évidements (9X, 9Y) et de deuxièmes protubérances (8) entourées par les deuxièmes évidements (9X, 9Y),
dans une section transversale de ladite deuxième structure de surface prise le long d'un plan (P) qui croise la limite (C) entre ladite face de coupe (1A) et ledit flanc (1B), le nombre de deuxièmes protubérances (8) satisfaisant la condition selon laquelle une troisième inclinaison (8XG) est plus importante qu'une quatrième inclinaison (8YG) est supérieur au nombre de deuxièmes protubérances (8) satisfaisant la condition selon laquelle la troisième inclinaison (8XG) n'est pas plus importante que la quatrième inclinaison (8YG), la troisième inclinaison (8XG) étant une inclinaison de la même première surface latérale (8X) de chaque protubérance (8) qui est incluse dans les deuxièmes protubérances (8), la première surface latérale (8X) conduisant à un évidement adjacent (9X) sur un côté de la limite (C), la quatrième inclinaison (8YG) étant une inclinaison de l'autre surface latérale (8Y) de chaque protubérance (8), et l'autre surface latérale (8Y) conduisant à un évidement adjacent (9Y) du côté opposé à la limite (C), et
ladite deuxième structure de surface a une structure amorphe, l'intérieur de l'outil tranchant se trouvant sous ladite deuxième structure de surface a une structure cristalline, et une région de limite entre l'intérieur dudit outil tranchant et ladite deuxième structure de surface a une structure qui passe progressivement de la structure cristalline à la structure amorphe à mesure qu'elle va de l'intérieur dudit outil tranchant à ladite deuxième structure de surface.

7. Procédé de fabrication d'un outil tranchant selon l'une quelconque des revendications 1 à 6,
dans lequel chacune parmi ladite première structure de surface et ladite deuxième structure de surface est formée par l'irradiation avec un faisceau d'ions d'amas gazeux.
